# EUROPÄISCHE PATENTSCHRIFT

(11) **EP 0 825 721 B1**
(45) Veröffentlichungstag und Bekanntmachung des Hinweises auf die Patenterteilung: **16.10.2002**
(21) Anmeldenummer: 97111342.8
(22) Anmeldetag: 04.07.1997
(51) Int. Cl.: H03M 1/68, H03M 1/00

(54) **Voll differentieller Digital-Analog-Wandler mit geringer Anzahl von Widerständen**
Fully differential digital to analogue converter having a low number of resistors
Convertisseur numérique-analogique entièrement différentiel à nombre de résistances réduit

(30) Priorität: 08.08.1996 DE 19632093
(43) Veröffentlichungstag der Anmeldung: 25.02.1998
(73) Patentinhaber: Infineon Technologies AG, 81669 München (DE)
(72) Erfinder: Sauerbrey, Jens, 81549 München (DE); Kiehl, Oliver, Dr., Essex Junction, VT 05452 (US)
(74) Vertreter: Reinhard - Skuhra - Weise & Partner

(56) Entgegenhaltungen:
- WO-A-96/16481
- US-A- 4 393 370
- US-A- 4 899 151
- US-A- 5 059 978
- VOGT A W ET AL: "A 10-BIT HIGH-SPEED CMOS DAC MACROCELL" , PROCEEDINGS OF THE CUSTOM INTEGRATED CIRCUITS CONFERENCE,US,NEW YORK, IEEE, VOL. CONF. 11, PAGE(S) 671-674 XP000075534 * Seite 6.7.1, rechte Spalte; Abbildung 1 *
- AGAZZI O ET AL: "AN ANALOG FRONT END FOR FULL-DUPLEX DIGITAL TRANSCEIVERS WORKING ONTWISTED PAIRS" , PROCEEDINGS OF THE CUSTOM INTEGRATED CIRCUITS CONFERENCE,US,NEW YORK, IEEE, VOL. CONF. 10, PAGE(S) 2641-2644 XP000124786 * Abbildung 4 *

## Beschreibung

Unter einem Digital-Analog-Wandler wird hierbei ein sog. Resistor-String D/A-Converter verstanden. Bekannte Digital-Analog-Wandler dieser Art weisen, bei einer Auflösung von k Bit, 2^{k} in Serie geschaltete Widerstände auf, die alle gleich groß sind und an denen gegen Masse 2^{k} Teilspannungen abgegriffen werden können. Nachteilig sind hierbei die im Vergleich zu anderen Digital-Analog-Umsetzungsprinzipien große Anzahl von Widerständen und damit die große Fläche, die für große Auflösungen zu relativ großen parasitären Kapazitäten und daher zu relativ großen Einschwingzeiten führt.

Aus der US-Patentschrift 5,059,978 ist ein Resistor-String D/A-Converter bekannt, bei dem zusätzlich ein bzw. zwei Resistor-Strings parallel geschaltet sind, um den effektiven Widerstand der Knoten in der Widerstandskette zu verkleinern und damit auch das zeitliche Verhalten zu verbessern.

Soll der Digital-Analog-Wandler ein voll differentielles Ausgangssignal ausgeben, so muß ein positiver und ein negativer Zweig getrennt dekodiert werden. Im Unterschied zur sog. "Single ended-Realisierung" muß jeder Knoten in der Widerstandskette den beiden Zweigen getrennt abgegriffen werden können, was die Anzahl der benötigten Schalter auf 2*2^{k} anwachsen läßt. Der Vorteil der voll differentiellen Ansteuerung besteht im vergrößerten Signalhub und im verbesserten Power Supply Rejection Ratio (PSRR).

Die der Erfindung zugrundeliegende Aufgabe besteht nun darin, einen voll differentiellen Resistor-String Digital-Analog-Wandler anzugeben, der möglichst geringe Einschwingzeiten aufweist. Diese Aufgabe wird erfindungsgemäß durch die Merkmale der Patentansprüche 1 oder 4 gelöst, wobei der Gegenstand des Patentanspruchs 4 noch zusätzlich den Vorteil einer besonders geringen Chipfläche aufweist. Vorteilhafte Ausgestaltungen der Erfindung ergeben sich aus den Unteransprüchen.

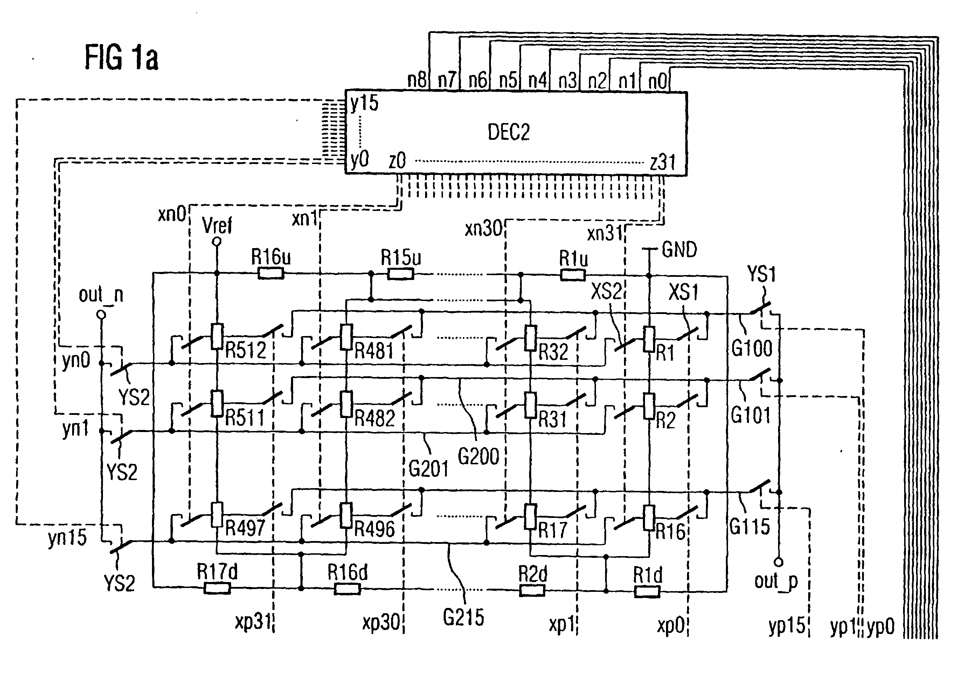

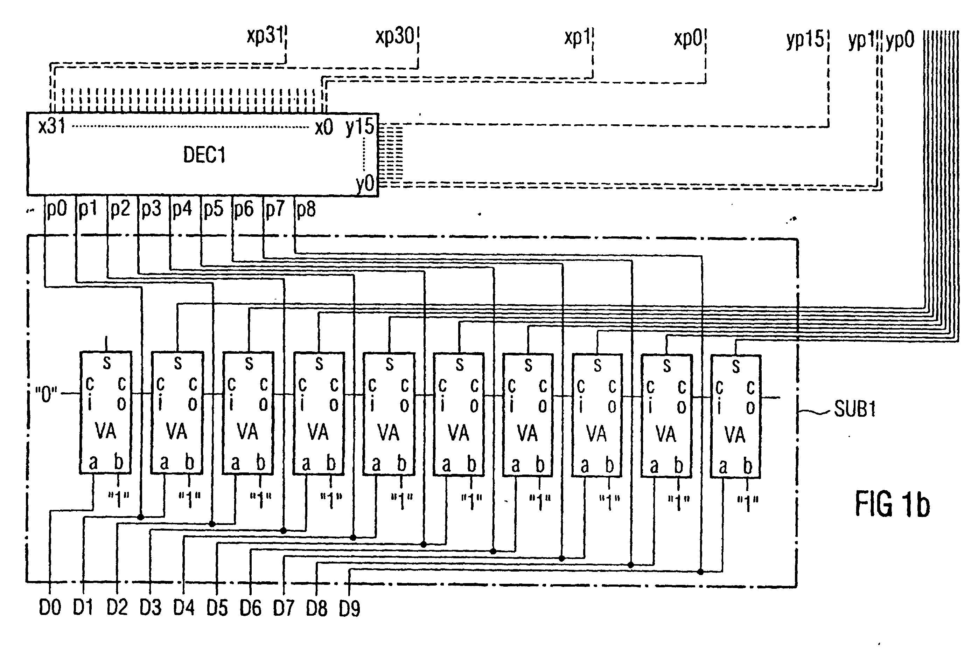

Die Erfindung wird im folgenden anhand der Zeichnung näher erläutert. Die Zeichnung zeigt beispielhaft einen erfindungsgemäßen 10 Bit Digital-Analog-Wandler, der im folgenden kurz als DAC bezeichnet wird. Der DAC weist ein matrixförmiges Widerstandsnetzwerk, zwei Dekoder DEC1 und DEC2 sowie eine Subtrahiereinheit SUB1 auf. Dem DAC wird ein Eingangsdatenwort mit den Datenbits D0 ...D9 zugeführt, die alle bis auf das LSB den Eingängen p0 ..p8 des Dekoders DEC1 zugeführt werden. In der Subtrahiereinheit SUB1, die hier aus 10 Volladdierern VA besteht, wird von dem 10 Bit-Eingangsdatenwort D0 ... D9 die Zahl 1 durch Addition des Wertes 11111 11111 subtrahiert. Alle Summenausgänge der Volladdierer bis auf den Summenausgang des Volladdierers für das LSB werden den neun Eingängen n0 ... n8 des zweiten Dekoders DEC2 zugeführt.

Allgemein ausgedrückt sind also für einen DAC mit einer Auflösung k zwei Dekoder mit je einer Auflösung von k-1 Bit erforderlich. Die beiden Dekoder DEC1 und DEC2 können vorteilhafterweise gleich aufgebaut werden und wählen für jede Bitkombination am Eingang des Dekoders genau eine Spalte der Spalten x0 .. x31 und genau eine Zeile der Zeile y0 .. y15 des matrixförmigen Widerstandsnetzwerkes aus.

Um die Chipfläche optimal zu nutzen, ist es zweckmäßig, das Widerstandsnetzwerk möglichst quadratisch auszulegen, wodurch sich die Zeilenzahl und Spaltenzahl der beiden Dekoder höchstens um 1 unterscheidet und zwar dann, wenn die Bitbreite der Dekoder ungeradzahlig ist. Die hier in diesem Beispiel gezeigten Dekoder DEC1 und DEC2 mit einer Auflösung von jeweils neun Bit weisen 2⁵ Spaltenausgänge x0 ...x31 und 2⁴ Zeilenausgänge y0 .. y15 auf.

Das Widerstandsnetzwerk selbst weist eine mäanderförmig angeordnete Reihenschaltung von 2^{k-1} Widerständen R1 .. R512 mit Mittelabgriff auf, wobei die Mittelabgriffe jeweils über Schalter XS1 mit ersten Grobauswahlleituhgen G100 - G115 und über Schalter XS2 mit zweiten Grobauswahlleitungen G200 - G215 derart verbunden sind, daß bei einem der beiden Dekoder mit steigender Bitwertigkeit der Grobauswahl an den Dekoderausgängen x0 .. x31 steigende Spaltennummern und bei dem anderen Dekoder mit steigender Bitwertigkeit fallende Spaltennummern des matrixförmigen Widerstandsnetzwerkes adressiert werden. Die Schalter XS1 werden dabei von den Spaltenausgängen x0 .. x31 des Dekoders DEC1 und die Schalter XS2 durch die Spaltenausgänge x0 .. x31 des Dekoders DEC2 angesteuert. Die ersten Grobauswahlleitungen G100 - G115 sind durch Schalter YS1 mit einem ersten analogen Differenzausgang out_p und die Grobauswahlleitungen G200 - G215 über Schalter YS2 mit einem zweiten analogen Differenzausgang out_p verbindbar. Die Schalter YS1 werden dabei durch die Zeilenausgänge y0 .. y15 des Dekoders DEC1 und die Schalter YS2 durch die Zeilenausgänge y0 .. y15 des Dekoders DEC2 angesteuert. Mit Hilfe der hier jeweils 16 Schalter YS1 und YS2 wird eine Feinauswahl der durch die Schalter XS1 und XS2 bereits grob ausgewählten Spannungen vorgenommen.

Zur Senkung der Gesamtimpedanz des Widerstandsnetzwerkes sind gerade bei DACs für hohe Schaltfrequenzen vorteilhafterweise zusätzlich eine Widerstandskette aus den Widerständen R1u R16u sowie eine weitere Widerstandskette mit den Widerständen R1d .. R17d vorgesehen. Die Widerstände dieser Widerstandsteilerketten sind im Vergleich zu den übrigen Widerständen wesentlich niederohmiger und sorgen dafür, daß nach jeder Spalte, also hier nach jeweils 16 Widerständen der mäanderförmig angeordneten Reihenschaltung eine Verbindung zu einer relativ niederohmig vorliegenden Teilspannung einer gesamten Referenzspannung Vref besteht. Ein jeweiliger Beginn einer Spalte des Widerstandsnetzwerkes ist dabei mit einem Abgriff der ersten Widerstandsteilerkette und das jeweilige Ende einer Spalte mit einem Abgriff der zweiten Widerstandsteilerkette verbunden. Durch dieses Maßnahme wird bei annähernd gleichbleibender Kapazität der ohmsche Widerstand des Widerstandsnetzwerkes und damit auch die Schaltzeit des DAC verkleinert.

Durch die Erfindung wird bei einem entsprechenden DAC die Anzahl der Widerstände halbiert. In diesem Beispiel sind also nicht 2^{k} = 1024 Widerstände, sondern nur 2^{k-1} = 512 Widerstände erforderlich. Dies hat den Vorteil, daß die Widerstandsmatrix nur noch die Hälfte der Fläche benötigt. Die Halbierung der Anzahl der Widerstände verringert zum einen die parasitären Kapazitäten, die das Einschwingverhalten des Widerstandsnetzwerkes bestimmen. Andererseits muß beim Layout der Widerstände R1...R512 das Verhältnis von Länge/Weite verdoppelt werden, um einen vergleichbaren Strom im Widerstandsnetzwerk zu erhalten, da der Flächenwiderstand eine Konstante darstellt. Die Verdoppelung des Verhältnisses geschieht durch Halbierung der Weite der Widerstände. Diese Halbierung der Weite führt wiederum zu einer Verringerung der parasitären Kapazität und damit zu einer vergrößerten Schaltgeschwindigkeit des DAC. Im Vergleich zu bekannten voll differentiellen Resistor-String DACs kann hierbei bei gleicher Leistungsaufnahme die Einschwingzeit auf weniger als 50 % reduziert werden. Bei gleicher Einschwingzeit bedeutet dies eine deutliche Reduzierung des benötigten Stromes und damit der Leistung.

Würde das Eingangsdatenwort D0...D9 schrittweise jeweils um die Zahl 1 erhöht werden, so würde abwechselnd das Eingangswort des Dekoders DEC1 und mit der nächsten Erhöhung des Eingangswortes das Eingangssignal des Dekoders DEC2 usw. erhöht werden. Auf diese Weise wird eine Auflösung von k Bit erreicht, obwohl nur zwei 2^{k-1} Widerstände in der mäanderförmigen Reihenschaltung vorgesehen sind und die beiden Dekoder nur die Bitbreite k-1 aufweisen. Das am DAC anliegende Wort darf Werte zwischen 1 und 1023 annehmen. Auf diese Weise ist. gewährleistet, daß bei einem Eingangsdatenwort in der Mitte des definierten Eingangsbereiches, von hier beispielsweise 512 eine differentielle Ausgangsspannung von 0 Volt anliegt. Außerdem wird verhindert, daß es bei einem Eingangsdatenwort mit dem Wert von 0 zu einem Überlauf in der nur k Bit breiten Subtrahiereinheit SUB1 kommt.

Eine weitere Ausgestaltung der Erfindung weist, anstelle des einen Widerstandsnetzwerkes mit 2^{k-1} Widerständen, zwei Widerstandsnetzwerke mit je 2^{k-1} Widerständen auf, wobei die Mittelabgriffe der Widerstände des ersten Widerstandsnetzwerkes nur über die Schalter XS1 auf die ersten Grobauswahlleitungen G100...G115 und die Mittelabgriffe der Widerstände des zweiten Widerstandsnetzwerkes nur über die Schalter XS2 auf die zweiten Grobauswahlleitungen G200...G215 durchschaltbar sind. Bei dieser Ausgestaltung werden zwar ebenfalls, wie bei bekannten DACs dieser Art, 2^{k} Widerstände benötigt aber die Impedanz der Widerstandsnetzwerke und damit auch die Schaltgeschwindigkeit des DACs werden auch in diesem Fall gegenüber bekannten DACs dieser Art verbessert.

## Patentansprüche

1. Voll differentieller Digital-Analog-Wandler,
- bei dem ein erstes und ein zweites matrixförmiges Widerstandsnetzwerk, ein erster Dekoder (DEC1), ein zweiter Dekoder (DEC2) und eine Subtrahiereinheit (SUB1) vorgesehen sind,
- bei dem ein Eingangsdatenwort mit k Datenbits (D0 ...D9) dem ersten Dekoder direkt und einem zweiten Dekoder über die Subtrahiereinheit zugeführt sind, wobei die Subtrahiereinheit das Eingangsdatenwort um die Ziffer 1 dekrementiert,
- bei dem das erste und das zweite Widerstandsnetzwerk jeweils eine mäanderförmig angeordnete Reihenschaltung von 2^{k-1} Widerständen (R1 .. R512) mit Mittelabgriff aufweisen, wobei die Mittelabgriffe der Widerstände des ersten Widerstandsnetzwerkes jeweils über durch den ersten Dekoder angesteuerte Schalter (XS1) mit ersten Grobauswahlleitungen (G100 ... G115) und die Mittelabgriffe der Widerstände des zweiten Widerstandsnetzwerkes jeweils über durch den zweiten Dekoder angesteuerte Schalter (XS2) mit zweiten Grobauswahlleitungen (G200 ... G215) derart verbindbar sind, daß bei einem der beiden Dekoder mit steigender Bitwertigkeit eines zugehörigen Dekodereingangssignals (p0 .. p8) steigende Spaltennummern (x0 .. x31) und dem anderen Dekoder mit steigender Bitwertigkeit eines zugehörigen Dekodereingangssignals (n0 .. n8) fallende Spaltennummern (x31 .. x0) adressiert werden, und
- bei dem die ersten Grobauswahlleitungen über weitere durch den ersten Dekoder angesteuerte Schalter (YS1) mit einem ersten analogen Differenzausgang (out_p) und die zweiten Grobauswahlleitungen über weitere, durch den zweiten Dekoder angesteuerte Schalter (YS2) mit einem zweiten analogen Differenzausgang (out_p) verbindbar sind.

2. Voll differentieller Digital-Analog-Wandler nach Anspruch 1, bei dem zu jedem der beiden Widerstandsnetzwerke jeweils eine erste und zweite Widerstandskette mit im Vergleich zu den 2^{k-1} Widerständen des ersten und zweiten Widerstandsnetzwerkes niederohmigen Teilwiderständen (R1u ... R16u, R1d .. R17d) vorgesehen sind, wobei bei jedem Widerstandsnetzwerk ein jeweiliger Beginn einer Spalte des jeweiligen Widerstandsnetzwerkes mit einem Abgriff der ersten Widerstandsteilerkette und das jeweilige Ende einer Spalte mit einem Abgriff der zweiten Widerstandsteilerkette verbunden ist.

3. Voll differentieller Digital-Analog-Wandler nach Anspruch 1 oder 2, bei dem die beiden Widerstandsnetzwerke so ausgebildet sind, daß sich jeweils die Spaltenzahl höchstens um die Zahl 1 von der Zeilenzahl unterscheidet.

4. Voll differentieller Digital-Analog-Wandler,
- bei dem ein matrixförmiges Widerstandsnetzwerk, ein erster Dekoder (DEC1), ein zweiter Dekoder (DEC2) und eine Subtrahiereinheit (SUB1) vorgesehen sind,
- bei dem ein Eingangsdatenwort mit k Datenbits (D0 ...D9) dem ersten Dekoder direkt und einem zweiten Dekoder über die Subtrahiereinheit zugeführt sind, wobei die Subtrahiereinheit das Eingangsdatenwort um die Ziffer 1 dekrementiert,
- bei dem das Widerstandsnetzwerk eine mäanderförmig angeordnete Reihenschaltung von 2^{k-1} Widerständen (R1 .. R512) mit Mittelabgriff aufweist, wobei die Mittelabgriffe jeweils über durch den ersten Dekoder angesteuerte Schalter (XS1) mit ersten Grobauswahlleitungen (G100 ... G115) und über durch den zweiten Dekoder angesteuerte Schalter (XS2) mit zweiten Grobauswahlleitungen (G200 ... G215) derart verbindbar sind, daß bei einem der beiden Dekoder mit steigender Bitwertigkeit eines zugehörigen Dekodereingangssignals (p0 .. p8) steigende Spaltennummern (x0 .. x31) und dem anderen Dekoder mit steigender Bitwertigkeit eines zugehörigen Dekodereingangssignals (n0 .. n8) fallende Spaltennummern (x31 .. x0) adressiert werden, und
- bei dem die ersten Grobauswahlleitungen über weitere, durch den ersten Dekoder angesteuerte Schalter (YS1) mit einem ersten analogen Differenzausgang (out_p) und die zweiten Grobauswahlleitungen über weitere, durch den zweiten Dekoder angesteuerte Schalter (YS2) mit einem zweiten analogen Differenzausgang (out_p) verbindbar sind.

5. Voll differentieller Digital-Analog-Wandler nach Anspruch 4, bei dem eine erste und zweite Widerstandskette mit im Vergleich zu den 2^{k-1} Widerständen des Widerstandsnetzwerkes niederohmigen Teilwiderständen (R1u ... R16u, R1d .. R17d) vorgesehen sind, wobei ein jeweiliger Beginn einer Spalte des Widerstandsnetzwerkes mit einem Abgriff der ersten Widerstandsteilerkette und das jeweilige Ende einer Spalte mit einem Abgriff der zweiten Widerstandsteilerkette verbunden ist.

6. Voll differentieller Digital-Analog-Wandler, nach Anspruch 4 oder 5, bei dem das Widerstandsnetzwerk so ausgebildet ist, daß sich die Spaltenzahl höchstens um die Zahl 1 von der Zeilenzahl unterscheidet.

## Claims

1. Fully differential digital-to-analogue converter,
- in which a first and a second matrix-shaped resistor network, a first decoder (DEC1), a second decoder (DEC2) and a subtraction unit (SUB1) are provided,
- in which an input data word having k data bits (D0 ... D9) is fed directly to the first decoder and via the subtraction unit to a second decoder, the subtraction unit decrementing the input data word by the digit 1,
- in which the first and the second resistor network each contain 2^{k-1} resistors (R1 .. R512), with centre tap, connected in series in a meandering arrangement, where each of the centre taps of the resistors of the first resistor network can be connected via switches (XS1) controlled by the first decoder to first coarse-selection lines (G100 ... G115), and each of the centre taps of the resistors of the second resistor network can be connected via switches (XS2) controlled by the second decoder to second coarse-selection lines (G200 ... G215), in such a way that in one of the two decoders, column numbers (x0 .. x31) are addressed in ascending order for increasing bit significance of an associated decoder input signal (p0 .. p8), and in the other decoder, column numbers (x31 .. x0) are addressed in descending order for increasing bit significance of an associated decoder input signal (n0 .. n8), and
- in which the first coarse-selection lines can be connected via additional switches (YS1) controlled by the first decoder to a first analogue differential output (out_p), and the second coarse-selection lines can be connected via additional switches (YS2) controlled by the second decoder to a second analogue differential output (out_n).

2. Fully differential digital-to-analogue converter according to Claim 1, in which a first and second resistor chain containing sub-resistors (R1u ... R16u, R1d .. R17d) having resistances lower than the 2^{k-1} resistors of the first and second resistor network are provided for each of the two resistor networks, where in each resistor network a particular start of a column of the resistor network concerned is connected to a tap from the first resistor divider chain, and the corresponding end of a column is connected to a tap from the second resistor divider chain.

3. Fully differential digital-to-analogue converter according to Claim 1 or 2, in which the two resistor networks are designed in such a way that in each case the column number differs from the row number by the number 1 maximum.

4. Fully differential digital-to-analogue converter,
- in which a matrix-shaped resistor network, a first decoder (DEC1), a second decoder (DEC2) and a subtraction unit (SUB1) are provided,
- in which an input data word having k data bits (D0 ... D9) is fed directly to the first decoder and via the subtraction unit to a second decoder, the subtraction unit decrementing the input data word by the digit 1,
- in which the resistor network contains 2^{k-1} resistors (R1 .. R512), with centre tap, connected in series in a meandering arrangement, where each of the centre taps can be connected via switches (XS1) controlled by the first decoder to first coarse-selection lines (G100 ... G115), and via switches (XS2) controlled by the second decoder to second coarse-selection lines (G200 ... G215), in such a way that in one of the two decoders, column numbers (x0 .. x31) are addressed in ascending order for increasing bit significance of an associated decoder input signal (p0 .. p8), and in the other decoder column numbers (x31 .. x0) are addressed in descending order for increasing bit significance of an associated decoder input signal (n0 .. n8), and
- in which the first coarse-selection lines can be connected via additional switches (YS1) controlled by the first decoder to a first analogue differential output (out_p), and the second coarse-selection lines can be connected via additional switches (YS2) controlled by the second decoder to a second analogue differential output (out_n).

5. Fully differential digital-to-analogue converter according to Claim 4, in which a first and second resistor chain containing sub-resistors (R1u ... R16u, R1d .. R17d) having resistances lower than the 2^{k-1} resistors of the resistor network are provided, where a particular start of a column of the resistor network is connected to a tap from the first resistor divider chain, and the corresponding end of a column is connected to a tap from the second resistor divider chain.

6. Fully differential digital-to-analogue converter according to Claim 4 or 5, in which the resistor network is designed in such a way that the column number differs from the row number by the number 1 maximum.

## Revendications

1. Convertisseur numérique-analogique entièrement différentiel,
- dans lequel il est prévu un premier et un second réseaux de résistances en forme de matrices, un premier décodeur (DEC1), un deuxième décodeur (DEC2) et une unité de soustraction (SUB1),
- dans lequel un mot de données d'entrée avec k bits de données (D0 ... D9) est acheminé directement au premier décodeur et via l'unité de soustraction à un deuxième décodeur, l'unité de soustraction décrémentant le mot de données d'entrée du chiffre 1,
- dans lequel le premier et le second réseaux de résistances présentent respectivement un montage en série agencé en méandres de 2^{k-1} résistances (R1 ... R512) avec une prise centrale, les prises centrales des résistances du premier réseau de résistances pouvant être connectées respectivement via des commutateurs (XS1) commandés par le premier décodeur à des premières lignes de sélection grossière (G100 - G 115) et les prises centrales des résistances du second réseau de résistances pouvant être connectées respectivement via des commutateurs (XS2) commandés par le second décodeur à des deuxièmes lignes de sélection grossière (G200...G215) de telle sorte que, dans l'un des deux décodeurs, soient adressés des numéros de colonnes (x0 ... x31) croissant avec le poids binaire croissant d'un signal d'entrée de décodeur correspondant (p0 ... p8) et que, dans l'autre décodeur, soient adressés des nombres de colonnes (x31 ... x0) diminuant avec le poids binaire croissant d'un signal d'entrée de décodeur correspondant (n0 ... n8), et
- dans lequel les premières lignes de sélection grossière peuvent être connectées par d'autres commutateurs (YS1) commandés par le premier décodeur à une première sortie différentielle analogique (out_p) et les secondes lignes de sélection grossière peuvent être connectées par d'autres commutateurs (YS2) commandés par le second décodeur à une seconde sortie différentielle analogique (out_p).

2. Convertisseur numérique-analogique entièrement différentiel selon la revendication 1, dans lequel, dans chacun des deux réseaux de résistances, il est prévu respectivement une première et une seconde chaînes de résistances avec des résistances partielles faiblement ohmiques (R1u ... R16u, R1d ... R17d) en comparaison des 2^{k-1} résistances du premier et du second réseaux de résistances, où, dans chaque réseau de résistances, un début respectif d'une colonne du réseau de résistances respectif est connecté à une prise de la première chaîne de diviseur de résistances et la fin respective d'une colonne à une prise de la seconde chaîne de diviseurs de résistances.

3. Convertisseur numérique-analogique entièrement différentiel selon la revendication 1 ou 2, dans lequel les deux réseaux de résistances sont conformés de telle sorte que le nombre de colonnes se distingue respectivement du nombre de lignes au maximum du chiffre 1.

4. Convertisseur numérique-analogique entièrement différentiel,
- dans lequel il est prévu un réseau de résistances en forme de matrice, un premier décodeur (DEC1), un second décodeur (DEC2) et une unité de soustraction (SUB1),
- dans lequel un mot de données d'entrée avec k bits de données (D0 ... D9) est acheminé au premier décodeur directement et au second décodeur via l'unité de soustraction, l'unité de soustraction décrémentant du chiffre 1 le mot de données d'entrée,
- dans lequel le réseau de résistances présente un montage en série agencé en méandres de 2^{k-1} résistances (R1 ... R512) avec une prise centrale, les prises centrales pouvant être connectées respectivement par des commutateurs (XS1) commandés par le premier décodeur à des premières lignes de sélection grossière (G100 ... G115) et par des commutateurs (XS2) commandés par le second décodeur à des secondes lignes de sélection grossière (G200 ... G215) de telle sorte que, dans l'un des deux décodeurs soient adressés des nombres de colonnes (x0 ... x31) croissant avec le poids binaire croissant d'un signal d'entrée de décodeur correspondant (p0 ... p8) et que dans l'autre décodeur soient adressés des nombres de colonnes (x31 ... x0) diminuant avec le poids binaire croissant d'un signal d'entrée de décodeur correspondant (n0 ... n8), et
- dans lequel les premières lignes de sélection grossière peuvent être connectées par d'autres commutateurs (YS1) commandés par le premier décodeur à une première sortie différentielle analogique (out_p) et les secondes lignes de sélection grossière par d'autres commutateurs (YS2) commandés par le second décodeur à une seconde sortie différentielle analogique (out_p).

5. Convertisseur numérique-analogique entièrement différentiel selon la revendication 4, dans lequel il est prévu une première et une seconde chaînes de résistances avec des résistances partielles faiblement ohmiques (R1u ... R16u, R1d ... R17d) en comparaison des 2^{k-1} résistances du réseau de résistances, où un début respectif d'une colonne du réseau de résistances est connecté à une prise de la première chaîne de diviseurs de résistances et la fin respective d'une colonne est connectée à une prise de la seconde chaîne de diviseurs de résistances.

6. Convertisseur numérique-analogique entièrement différentiel selon la revendication 4 ou 5, dans lequel le réseau de résistances est conformé de telle sorte que le nombre de colonnes se distingue du nombre de lignes au maximum du chiffre 1.
